(19) Europäisches Patentamt / European Patent Office / Office européen des brevets

(11) **EP 1 816 483 B1**

(12) **EUROPÄISCHE PATENTSCHRIFT**

(45) Veröffentlichungstag und Bekanntmachung des Hinweises auf die Patenterteilung:
**30.07.2008  Patentblatt 2008/31**

(51) Int Cl.:
*G01R 31/02* *(2006.01)*          *G01R 19/165* *(2006.01)*

(21) Anmeldenummer: **06002292.8**

(22) Anmeldetag: **03.02.2006**

(54) **Schaltung zur Kurzschluss- bzw. Überstromerkennung**

Short-circuit and overcurrent detection circuit

Circuit de détection de court-circuits et de surintensité de courant

(84) Benannte Vertragsstaaten:
**DE FR GB IT**

(43) Veröffentlichungstag der Anmeldung:
**08.08.2007  Patentblatt 2007/32**

(73) Patentinhaber: **SIEMENS AKTIENGESELLSCHAFT**
**80333 München (DE)**

(72) Erfinder: **Schwabe, Dietmar**
**08496 Neumark (DE)**

(56) Entgegenhaltungen:
**EP-A- 1 096 262          DE-A1- 4 119 917**
**US-B1- 6 967 488**

## Beschreibung

Die Erfindung betrifft eine Schaltung zur Erkennung eines Kurzschluss- bzw. Überstroms in einem Schaltungsteil oder einer Komponente. Dies kann unter anderem auch eine Analog-Ausgabebaugruppe sein, wobei die Forderung besteht, dass die Erkennung unabhängig vom Ausgabebereich der Baugruppe sein soll.

DE 4 119 917 offenbart eine Überstromdetektoreinrichtung. Die Schaltung besteht aus drei Stromkreisen die über zwei Stromspiegel verbunden sind.

Derartige bekannte Schaltungen lösen dieses Problem z.B. mittels Optokoppler, wobei hier die Genauigkeit gering und der Streubereich der Messung relativ hoch ist. Es sind auch Lösungen bekannt, die den Spannungsabfall über Widerstände in der Betriebsspannungszuführung des Ausgangstreibers zur Strommessung benutzen. Bei dieser Anordnung ergibt sich ein entsprechend hoher und linear mit dem Ausgangsstrom steigender Spannungsabfall und eine entsprechend hohe Wärmeentwicklung. Außerdem besteht hier die Notwendigkeit zur Messung auf der Seite des Ausgangstreibers mit hohem Potential.

Der Erfindung liegt die Aufgabe zugrunde, die oben genannte Schaltung derart zu verbessern, dass eine hohe Genauigkeit in der Strommessung mit einer niedrigen Streuung erreicht wird.

Diese Aufgabe wird gelöst mit einer Schaltung mit den Merkmalen nach Anspruch 1. Bei dieser ist in einer positiven und negativen Versorgungsleitung des Schaltungsteils oder der Komponente jeweils ein Stromspiegel eingesetzt. Hierdurch wird auf einfache Weise ein Messstrom erzeugt, der durch einen Messwiderstand geleitet wird und der an diesem eine zur Auswertung dienende Messspannung zur Folge hat.

Vorteilhafte Weiterbildungen der Schaltung sind den Unteransprüchen zu entnehmen.

Besonders vorteilhaft ist es, wenn die Ausgänge der Stromspiegel abschaltbar sind, um auf diese Weise den betreffenden Schaltungsteil oder die Komponente, z.B. einen Ausgangstreiber stromlos zu schalten.

Ein Ausführungsbeispiel der Erfindung wird im Folgenden anhand einer Zeichnung näher erläutert. Es zeigen:

FIG 1 eine erfindungsgemäße Schaltung zur Erkennung eines Kurzschluss- bzw. Überstroms in einem Ausgangstreiber und

FIG 2 eine Schaltung gemäß FIG 1 mit Mitteln zur Ausgangsabschaltung.

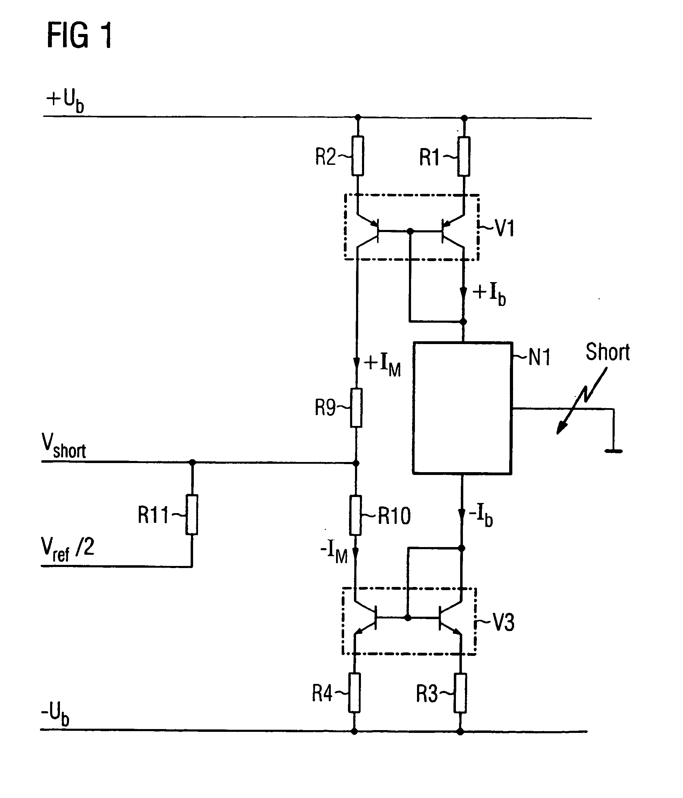

In FIG 1 ist eine Schaltung zur Erkennung eines Kurzschluss- bzw. Überstroms in einem Schaltungsteil oder einer Komponente, hier einem Ausgangstreiber N1 dargestellt. Dem Ausgangstreiber N1 wird über eine positive Versorgungsleitung ein positiver Belastungsstrom $+I_b$ zugeführt und über eine abgehende negative Versorgungsleitung fließt ein negativer Belastungsstrom $-I_b$ ab. Am Eingang der positiven Versorgungsleitung leigt die Spannung $+U_b$ und am Eingang der negativen Versorgungsleitung die Spannung $-U_b$ an. In der positiven Versorgungsleitung ist ein erster Stromspiegel und in der negativen Versorgungsleitung ein zweiter Stromspiegel eingesetzt, durch die entsprechenden Belastungsströme $+I_b$ bzw. $-I_b$ fließen. Der erste Stromspiegel V1 ist mit mit einem Widerstand R1 und einem zweiten Widerstand R2 beschaltet, die beiden einen gespiegelten Messstrom

$+I_M$ gemäß der Beziehung $+ \quad +\ I_M\ =\ \dfrac{R1}{R2}\ \cdot\ +I_b$

zur Folge haben. Der zweite Stromspiegel V3 ist mit einem dritten Widerstand R3 und einem vierten Widerstand R4 beschaltet, die beide einen gespiegelten

Messstrom $-\quad -\ I_M\ =\ \dfrac{R3}{R4}\ \cdot\ -I_b$ zur Folge haben.

Der Messstrom $+I_M$ fließt über eine Reihenschaltung aus einem fünften Widerstand R9 und einem sechsten Widerstand R10 zwischen den beiden Stromspiegeln. An den Verbindungspunkt des fünften Widerstands R9 und des sechsten Widerstands R10 ist ein Messwiderstand R11 angeschlossen, an dem eine zum Messstrom $+I_M$ proportionale Messspannung $V_{short}$ abfällt, die der Auswertung dient.

Der erste Stromspiegel wird gebildet aus einem pnp-Doppeltransistor V1 und den beiden Widerständen R1 und R2. Der Betriebsstrom des Analogtreibers N1 sowie der Ausgangsstrom fließen in Summe als Belastungsstrom $+I_b$ durch den als Diode geschalteten rechten Transistor von V1 sowie durch den Widerstand R1. Der hier erzeugte Spannungsabfall erscheint wieder an der Basis-Emitterstrecke des linken Transistorteils von V1 und dem Widerstand R2. Bei einem Doppeltransistor wird davon ausgegangen, dass die Spannungen der Basis-Emitterstrecke praktisch gleich sind. Damit wird das Verhältnis der Ströme $+I_b$ und $+I_M$ vom Verhältnis der Widerstände R1 und R2 wie folgt bestimmt

$$\frac{+\ I_M}{+\ I_b}\ =\ \frac{R1}{R2}.$$

Der Messstrom $+I_M$ fließt durch den fünften Widerstand R9 und den eigentlichen Messwiderstand R11. An dem Messwiderstand R11 fällt proportional zum Messstrom $+I_M$ eine Spannung $V_{short}$ ab, die der Auswertung dient. Der fünfte Widerstand R9 schützt die hier nicht sichtbare Auswerteschaltung vor Überströmen aus dem Ausgangsbereich. Der Messwiderstand R11 liegt genau auf der halben Referenzspannung, um sowohl die positiven als auch negativen Ströme messen zu können.

Der maximale Messstrom $+I_{Mmax}$ muss so bemessen sein, dass am Messwiderstand R11 maximal die halbe Referenzspannung $V_{REF}$ abfällt

$$R11 = \frac{V_{REF}}{2 \cdot I_{M\,max}} \, .$$

Die am Messwiderstand R11 abfallende Spannung kann auf unterschiedliche Art und Weise ausgewertet werden. Im einfachsten Fall können mittels eines aus zwei Komparatoren aufgebauten Fensterdiskriminators entsprechende Signale abgeleitet werden, die von einem Controller oder einer anderen geeigneten Schaltung ausgewertet werden können. Bei höheren Anforderungen bzw. bei justierbaren oder umschaltbaren Schaltschwellen kann ein Analog/Digital-Wandler zur Auswertung benutzt werden, der z.B. im Controller vorhanden ist.

Der negative Teil der Schaltung wirkt praktisch entsprechend, nur dass der Messstrom $-I_M$ am Messwiderstand R11 einen auf das Bezugspotential gesehenen negativen Spannungsabfall bewirkt. Der sechste Widerstand R10 bewirt in Verbindung mit der Dimensionierung des Messwiderstands R11, dass die minimale Spannung $V_{short}$ immer etwas größer als Null ist. Damit ergibt sich insgesamt ein Ausgabebereich von etwa 0 Volt bis $V_{REF}$.

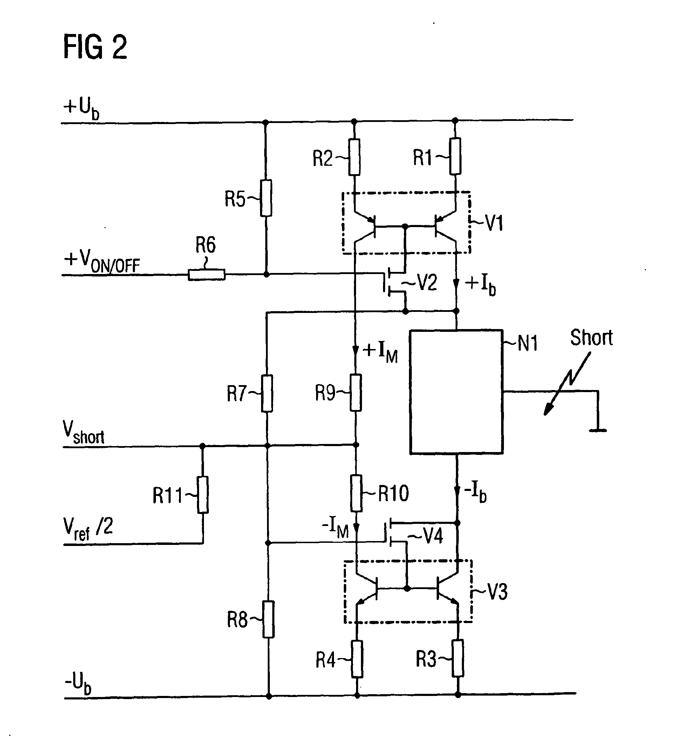

Die Schaltung gemäß FIG 2 unterscheidet sich von der gemäß FIG 1 dadurch, dass sie eine Ausgangsabschaltung aufweist. Hierzu ist eine Beschaltung vorgesehen, die neben einem ersten elektronischen Schalter V2 zur Abschaltung des ersten Stromspiegels einen zweiten elektronischen Schalter V4 zur Abschaltung des zweiten Stromspiegels und weitere Widerstände R5, R6, R7 und R8 aufweist. Soll der Ausgang spannungs- bzw. stromlos geschaltet werden, so wird ein Eingang $V_{ON/OFF}$ auf LOW gelegt. Der erste elektronische Schalter, beispielsweise ein P-Kanal-FET V2, öffnet und es kann kein Basisstrom mehr in den Doppeltransistor V1 fließen. Dies bewirkt das Sperren des Doppeltransistors V1. Somit wird auch der Stromfluss des Belastungsstroms $+I_b$ für den Ausgangstreiber N1 unterbrochen. Damit wird auch der Stromfluss in dem aus den beiden Widerständen R7 und R8 gebildeten Widerstandsteiler, der am Ausgang des ersten elektronischen Schalters V2 liegt, unterbrochen. Hierdurch wird auch der zweite elektronische Schalter, hier der N-Kanal-FET V4 gesperrt. Damit steht kein Basisstrom für den Doppeltransistor V3 zur Verfügung, so dass auch dieser sperrt und der Stromfluss des negativen Belastungsstroms- $I_b$ unterbrochen wird. Somit ist der gesamte Ausgangstreiber N1 stromlos geschaltet. Es ist auch denkbar, nur den Leistungsteil des Ausgangstreibers N1 stromlos zu schalten, während die Ansteuerschaltung weiterhin mit Betriebsstrom versorgt wird. Dies kann notwendig sein, wenn die Rückkehr aus dem stromlosen Zustand beschleunigt erfolgen soll.

Die erfindungsgemäße Kurzschluss- bzw. Überstromerkennung ist unabhängig vom Ausgabebereich der Baugruppe, d.h. sie funktioniert im gesamten Spannungsbereich von -10 V bis +10 V. Die Schaltung ist leicht an andere Verhältnisse, wie z.B. höhere Ströme, anpassbar. Die Ausgabe des Stromwerts ist linear und unipolar. Die Schwellwerte für die Auswertung lassen sich leicht anpassen und beliebig wählen. Ein Schutz der Folgeschaltung gegen zu hohe Ströme, z.B. bei Gegenspannung vom Ausgang her ist durch die Schaltungsausführung bereits gegeben.

Die Abschaltung der Ausgangstreiber ist mit einem einzigen Signal möglich. Da der Ausgangstreiber stromlos geschaltet wird, führt ein Fehlverhalten in der Treiberansteuerung nicht zur Spannungs- oder Stromausgabe. Zudem ist die erfindungsgemäße Lösung preiswert, da keine Sonderkomponenten erforderlich sind.

**Patentansprüche**

1. Schaltung zur Erkennung eines Kurzschluss- bzw. Überstroms, bei der in einer positiven und negativen Versorgungsleitung eines Schaltungsteils oder einer Komponente (N1) jeweils ein Stromspiegel eingesetzt ist, wobei ein erster Stromspiegel mit einem Doppeltransistor (V1) in der positiven Versorgungsleitung mit einem positiven Belastungsstrom $(+I_b)$ und ein zweiter Stromspiegel mit einem zweiten Doppeltransistor (V3) in der negativen Versorgungsleitung mit einem negativen Belastungsstrom $(-I_b)$ beaufschlagt ist und wobei der erste Stromspiegel einen ersten Widerstand (R1) und einen zweiten Widerstand (R2) aufweist, die beide einen gespiegelten Messstrom $(+I_M)$ gemäß der Beziehung

   $$+ I_M = \frac{R1}{R2} \cdot +I_b$$ zur Folge haben und wobei der zweite Stromspiegel (V3) einen dritten Widerstand (R3) und einen vierten Widerstand (R4) aufweist, die einen gespiegelten Messstrom $-I_M$ gemäß der Beziehung $- I_M = \frac{R3}{R4} \cdot -I_b$ zur

   Folge haben und wobei eine Reihenschaltung von einem fünften Widerstand (R9) und einem sechsten Widerstand (R10) zwischen den beiden Stromspiegeln liegt und wobei an den Verbindungspunkt des fünften und sechsten Widerstands (R9, R10) ein Messwiderstand (R11) angeschlossen ist, an dem eine zum Messstrom $(+I_M)$ proportionale Messspannung $(V_{short})$ abfällt, die der Auswertung dient.

2. Schaltung nach Anspruch 1, **dadurch gekennzeichnet, dass** ein maximaler Messstrom $(+I_{Mmax})$ derart bemessen ist, dass am Messwiderstand (R11) maximal die Hälfte einer Referenzspannung ($V_{REF}$) abfällt.

**3.** Schaltung nach Anspruch 1 oder 2, **dadurch gekennzeichnet, dass** die Ausgänge der beiden Stromspiegel abschaltbar sind.

**4.** Schaltung nach Anspruch 2, **dadurch gekennzeichnet, dass** zur Abschaltung des ersten Stromspiegels ein erster elektronischer Schalter (V2) und zur Abschaltung des zweiten Stromspiegels (V3) ein zweiter elektronischer Schalter (V4) vorgesehen ist.

**5.** Schaltung nach einem der vorangehenden Ansprüche, **dadurch gekennzeichnet, dass** die Komponente ein Ausgangstreiber (N1) ist.

**Claims**

**1.** Circuit for detecting a short-circuit current or overcurrent, wherein a current mirror is inserted in each case in a positive and negative supply line of a circuit section or component (N1), with a positive load current (+$I_b$) being applied to a first current mirror having a dual transistor (V1) in the positive supply line and a negative load current (-$I_b$) being applied to a second current mirror having a second dual transistor (V3) in the negative supply line, and with the first current mirror having a first resistor (R1) and a second resistor (R2), both of which result in a mirrored measuring current (+$I_M$) according to the relation

$$+ \; I_M \; = \; \frac{R1}{R2} \cdot + I_b \textbf{,}$$

and with the second current mirror (V3) having a third resistor (R3) and a fourth resistor (R4) which result in a mirrored measuring current -$I_M$ according to the relation

$$- \; I_M \; = \; \frac{R3}{R4} \cdot - I_b \textbf{,}$$

and with a series circuit from a fifth resistor (R9) and a sixth resistor (R10) lying between the two current mirrors, and with a measuring resistor (R11) being connected at the connecting point of the fifth and sixth resistor (R9, R10), at which measuring resistor (R11) there drops a measuring voltage ($V_{short}$) which is proportional to the measuring current (+$I_M$) and serves for evaluation purposes.

**2.** Circuit according to claim 1, **characterised in that** a maximum measuring current (+$I_{Mmax}$) is dimensioned such that maximally half of a reference voltage ($V_{REF}$) drops at the measuring resistor (R11).

**3.** Circuit according to claim 1 or 2, **characterised in**

**that** the outputs of the two current mirrors can be disconnected.

**4.** Circuit according to claim 2, **characterised in that** a first electronic switch (V2) is provided for disconnecting the first current mirror and a second electronic switch (V4) is provided for disconnecting the second current mirror (V3).

**5.** Circuit according to one of the preceding claims, **characterised in that** the component is an output driver (N1).

**Revendications**

**1.** Circuit de détection d'un court-circuit ou d'une surintensité de courant, dans lequel un miroir de courant est placé à chaque fois dans une ligne d'alimentation positive et négative d'une partie de circuit ou d'un composant (N1), dans lequel un premier miroir de courant avec un transistor double (V1) dans la ligne d'alimentation positive est alimenté avec un courant de charge positif (+ $I_b$) et un deuxième miroir de courant avec un deuxième transistor double (V3) dans la ligne d'alimentation négative est alimenté avec un courant de charge négatif (- $I_b$), dans lequel le premier miroir de courant comporte une première résistance (R1) et une deuxième résistance (R2) qui ont toutes deux pour conséquence un courant de mesure réfléchi (+ $I_M$) selon la relation

$$+ \; I_M \; = \; \frac{R1}{R2} \; \cdot \; + \; I_b$$

et le deuxième miroir de courant (V3) comporte une troisième résistance (R3) et une quatrième résistance (R4) qui ont pour conséquence un courant de mesure réfléchi -$I_M$ selon la relation

$$- \; I_M \; = \; \frac{R3}{R4} \; \cdot \; - \; I_b \textbf{,}$$

dans lequel un montage en série composé d'une cinquième résistance (R9) et d'une sixième résistance (R10) se trouve entre les deux miroirs de courant et dans lequel une résistance de mesure (R11) à laquelle chute une tension de mesure ($V_{short}$) proportionnelle au courant de mesure (+ $I_M$) et servant à l'évaluation est raccordée au point de jonction de la cinquième et de la sixième résistance (R9, R10) .

**2.** Circuit selon la revendication 1, **caractérisé par le fait qu'**un courant de mesure maximal (+ $I_{Mmax}$) est dimensionné de telle sorte que, au maximum, la moitié d'une tension de référence ($V_{REF}$) chute à la résistance de mesure (R11).

**3.** Circuit selon la revendication 1 ou 2, **caractérisé par le fait que** les sorties des deux miroirs de courant peuvent être coupées.

**4.** Circuit selon la revendication 2, **caractérisé par le fait qu'**un premier interrupteur électronique (V2) est prévu pour couper le premier miroir de courant et qu'un deuxième interrupteur électronique (V4) est prévu pour couper le deuxième miroir de courant (V3).

**5.** Circuit selon l'une des revendications précédentes, **caractérisé par le fait que** le composant est un circuit d'attaque de sortie (N1).

## FIG 1

$+U_b$

R2 R1

V1

$+I_b$

$+I_M$

R9

N1

Short

$V_{short}$

R11

$V_{ref}/2$

R10

$-I_b$

$-I_M$

V3

R4 R3

$-U_b$

# FIG 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4119917